# EUROPEAN PATENT SPECIFICATION

(11) **EP 0 398 742 B1**
(45) Date of publication and mention of the grant of the patent: **30.07.1997**
(21) Application number: 90305402.1
(22) Date of filing: 18.05.1990
(51) Int. Cl.: H03G 11/00

(54) **Clipping circuit**
Begrenzerschaltung
Circuit limiteur

(30) Priority: 19.05.1989 US 354327
(43) Date of publication of application: 22.11.1990
(73) Proprietor: GENNUM CORPORATION, Burlington, Ontario L7L 5P5 (CA)
(72) Inventor: Armstrong, Stephen Wade, Burlington, Ontario L7P 3V2 (CA)
(74) Representative: Barnard, Eric Edward

(56) References cited:
- EP-A- 0 237 203
- US-A- 4 004 242
- PATENT ABSTRACTS OF JAPAN vol. 11, no. 224 (E-525)(2671) 21 July 1987,& JP-A-62 042605 (MATSUSHITA) 24 February 1987,

## Description

This invention relates to clipping circuits. More particularly, it relates to such circuits for clipping signals substantially symmetrically.

### BACKGROUND OF THE INVENTION

Clipping is the limiting of the amplitude of an output signal when an input signal is above a given amplitude. Typically clipping occurs when the amplitude of the output signal reaches one of the supply rails, or an output stage driving transistor reaches its maximum output current by going into saturation or reaching maximum drive current.

For many applications, especially audio applications as described in US-A-4 004 242, it is desirable that clipping be performed symmetrically. Asymmetrical clipping introduces even harmonics to the output signal. Even harmonics do not naturally occur in audio signals and their presence can produce noticeable distortion for a listener.

Where clipping occurs as a result of the output signal amplitude reaching a supply rail at a different amplitude, with respect to the normal bias point of the output stage, from the amplitude at which the driving transistor reaches its maximum output current asymmetrical clipping will occur.

As a result, most output stages for applications where symmetrical clipping is desirable set the output stage bias point to be midway between one supply rail and the output voltage when the driving amplifier reaches its maximum output current. Typically, an output stage will consist of a bipolar junction transistor (BJT) amplifier whose emitter is connected to one supply rail and whose collector is connected through a resistor to the other supply rail. The input to the output stage is a current at the base of the transistor, while the output of the output stage is at the collector of the transistor. The only factor limiting upward signal excursion, assuming the other supply rail is a positive supply rail, is the difference between the bias point at the output and the positive supply rail. This difference is easily controlled. On the other hand the factors limiting downward signal excursion are the current gain of the amplifier, the driving current at the base of the amplifier and the saturation point of the amplifier. These factors are processing sensitive and interdependent. In order to obtain substantially symmetrical clipping each factor is set up at the time of processing and cannot be adjusted thereafter. In order to change the amount of clipping it is necessary to have separately processed circuits with each of the factors set for each desired clipping level.

### SUMMARY OF THE INVENTION

A clipping circuit in accordance with the invention comprises:
(a) a voltage reference stage having generating means for producing a reference voltage and an output port connected to said generating means for outputting said reference voltage;
(b) a transconductance stage having control means coupled to said output port of said voltage reference stage and, a first current source coupled to said control means, said first current source including means for generating a drive current having a first pre-determined value;
(c) said transconductance stage further including a gain stage coupled to said first current source for receiving current therefrom, said gain stage also being coupled to said control means;
(d) an input port for receiving an input signal, said input port being coupled to said output port of said voltage reference stage and to said control means;
(e) said control means including means responsive to said input signal for controlling the amount of said drive current flowing from said first current source to said gain stage;
(f) said gain stage including means responsive to the amount of said drive current received thereby for generating an output current proportional to the amount of said drive current received by said gain stage and for making said output current of said gain stage have a pre-determined maximum value proportional to said first pre-determined value;
(g) and bias means including feedback mean connect to said control means for biasing said control means to control said gain stage for said output current of said gain stage to have in the absence of any input signal, a steady-state value which is substantially one-half of said pre-determined maximum value.

### BRIEF DESCRIPTION OF THE DRAWINGS

For a better understanding of the present invention, and to show more clearly how it may be carried into effect, reference will now be made, by way of example, to the accompanying drawings, which show a preferred embodiments of the present invention, and in which:
Figure 1 is a block diagram of a clipping circuit according to the preferred embodiment of the present invention;
Figure 2 is a circuit diagram of the clipping circuit of Figure 1;
Figure 3 is a detailed circuit diagram of the clipping circuit of Figure 1 and
Figure 4 is a circuit diagram of the voltage reference stage with added impedance.

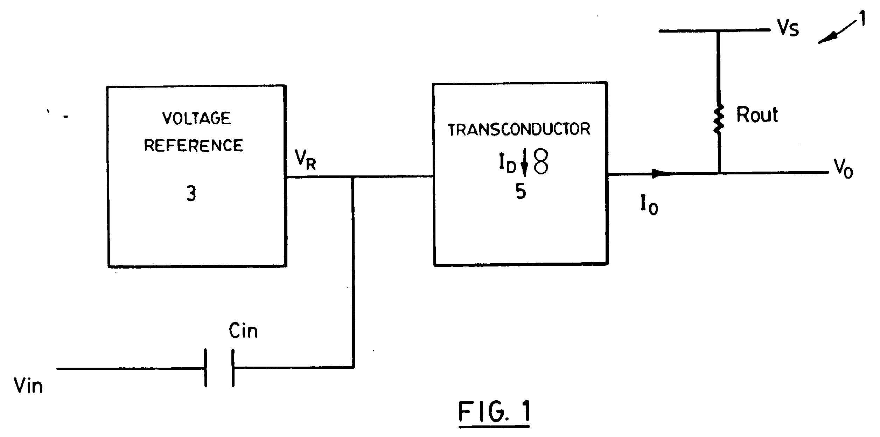

Referring to Figure 1, a symmetrical clipping circuit 1, in accordance with the invention, has a voltage reference stage 3 and a transconductance stage 5. The voltage reference stage 3 and the transconductance stage 5 are connected together and through a coupling capacitor Cᵢₙ to a voltage input Vᵢₙ. The voltage reference stage 3 outputs a reference voltage V_{R}. The output of the transconductance stage 5 is connected through a resistor Rₒᵤₜ to a first supply rail Vₛ.

An output voltage, Vₒ, is provided between Rₒᵤₜ and the output of the transconductance stage 5. The transconductance stage 5 outputs a current Iₒ as a function of the voltage input Vin and includes a source of limited drive current I_{D}. I_{D} is limited in the sense that it has a given maximum current. The reference voltage V_{R} sets a bias output current I_{obias} for the circuit 1.

V_{R} and I_{D} are matched so that a change in V_{R} is matched by a change in I_{Dmax} such that the bias output current I_{obias} is substantially one-half of a maximum output current Iₒₘₐₓ. It will be seen that a change in Vᵢₙ changes the input voltage to the transconductance stage 5, which will cause a change in the drive current I_{D}. As discussed, to ensure the symmetrical clipping circuit 1 modifies the output bias current I_{obias} so that it remains substantially one-half of the maximum output current Iₒₘₐₓ. The output voltage Vₒ is equal to Vₛ - Rₒᵤₜ x Iₒ. During steady state operation, the output current equal to output bias current I_{obias} and V_{obias} is Vₛ - I_{obias} x Rₒᵤₜ. The maximum upward signal swing from V_{obias}, assuming Vₛ is positive with respect to the output of the transconductance stage 5 and Iₒ is negative, occurs when I_{obias} is zero and is therefore I_{obias} x Rₒᵤₜ. The maximum downward signal swing from V_{obias} is Iₒₘₐₓ x Rₒᵤₜ - I_{obias} x Rₒᵤₜ. As Iₒₘₐₓ = 2 I_{obias} the maximum downward signal swing from V_{obias} is I_{obias} x Rₒᵤₜ. Thus the upward and downward signal swings are matched.

Rₒᵤₜ acts as a linear current controlled voltage source.

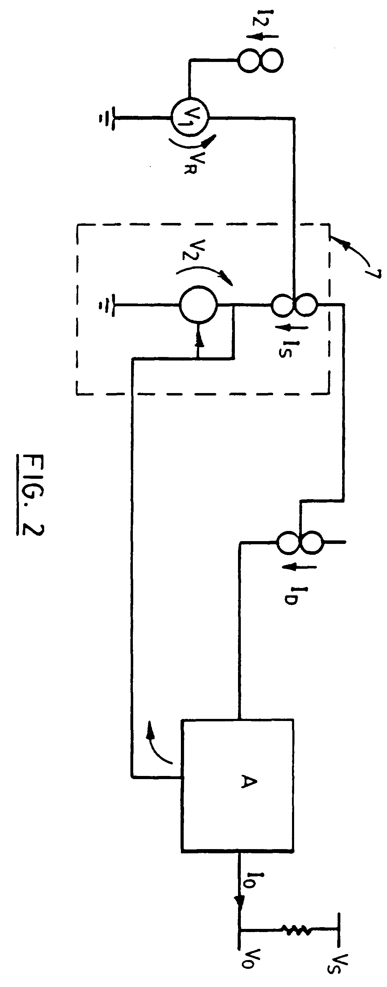

Referring to Figure 2, the transconductance stage 5 may be implemented using a gain controlled block A between I_{D} and Vₒ.

The gain block A is driven by the drive current I_{D}. The gain of block A is controlled in that the gain is known and can be implemented using a substantially processing insensitive component.

As the gain of block A is controlled the relationship between the proportion of I_{D} and the output current Iₒ is not affected by processing.

Connected between the source of drive current I_{D} and the voltage reference V_{R} is a voltage to current converter 7 outlined in dashed lines. The voltage to current converter 7 determines the amount of drive current I_{D} to be supplied to the controlled gain block A. The amount of drive current I_{D} is one-half of the difference between maximum and minimum drive current when there is a steady-state signal at the input to the transconductance stage 5. Otherwise, the amount of drive current I_{D} is proportional to the input to the transconductance stage 5 unless the maximum or minimum drive current is reached.

For the simplest implementation the minimum drive current should be set to zero (i.e. the source of drive current is shut off) and the maximum output current Iₒₘₐₓ is twice the steady-state output current I_{obias}. When this happens Vₒ swings between Vₛ when the drive current is zero and 2Rₒᵤₜ I_{obias} from V_{S}. This guarantees symmetrical clipping.

In order to communicate when the steady-state has been reached and what proportion of the maximum drive current is flowing, the controlled gain block A is connected back to the voltage to current converter 7. This connection provides a feedback loop 10.

The voltage reference stage 3 has a current controlled first voltage source V₁ connected between a second supply rail, in this case ground GND, and the output of the voltage reference V_{R}. The first voltage source V₁ is controlled by a second current source I₂.

The voltage to current converter 7 has a current controlled second voltage source V₂ and a voltage controlled current sink Iₛ. The current control input of the second voltage source V₂ is connected to the current sink Iₛ and to the gain block A via the feedback loop 10. The voltage control of the current sink Iₛ is connected between the second voltage source V₂ and the input to the transconductance 5. The current sink is connected to the source of driving current I_{D}.

In operation, based on the voltage input Vᵢₙ the voltage to current converter 7 determines the proportion of maximum drive current I_{D} presently flowing from the gain block A and represented in part as the voltage across the second voltage source V₂. An increase in the second voltage source will decrease the voltage at the control input to the current sink Iₛ, thereby decreasing the current being sunk. This decreases the output of the voltage to current converter 7 and decreases the amount of drive current I_{D}. Additionally it decreases the sunk current flowing into the current control input of the second voltage source V₂. Accordingly when the input voltage Vᵢₙ reaches a steady-state value the transconductance stage and the drive current I_{D} 5 will also reach a steady-state.

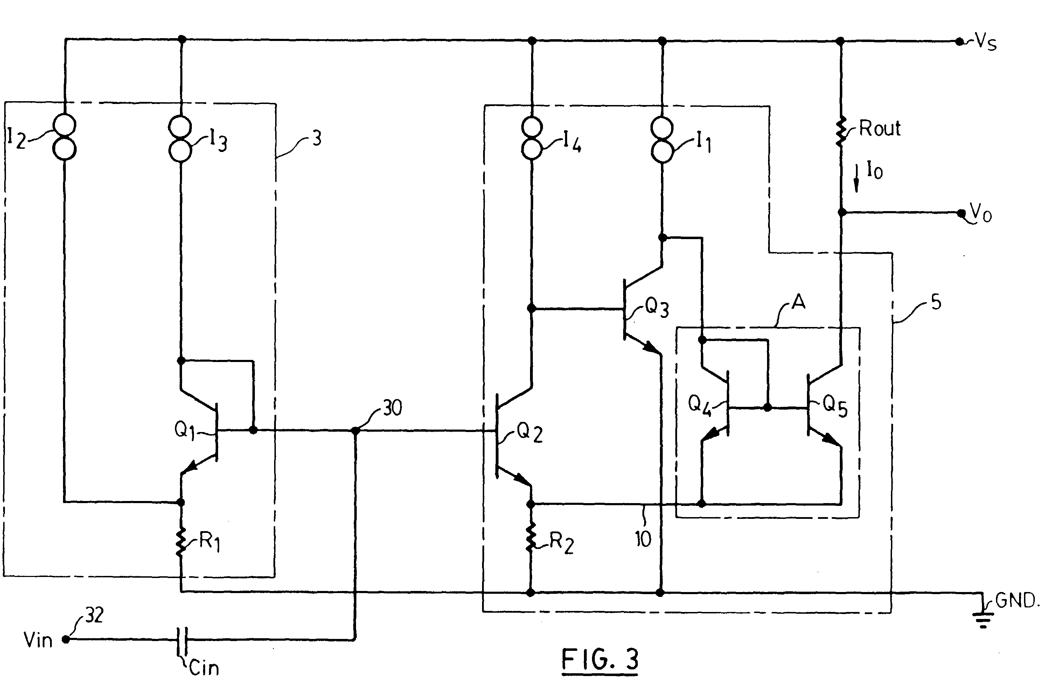

Referring now to Fig. 3, the current controlled first voltage source Vᵢ has been implemented using a diode connected first BJT Q₁ fed by a third current source I₃ and connected through a first passive element to the second supply rail GND. The first passive element is a resistor R₁. The reference voltage V_{R} is output at port 30 which also constitutes the input port for the transconductance stage 5. The signal input port for the circuit 1 for receiving Vin, is indicated at 32. A second current source I₂ is connected to Q₁ and R₁.

The voltage controlled current sink Iₛ is a second BJT Q₂ whose base is connected to the base of Q₁, and hence the input voltage Vin via the port 30 and the capacitor Cin, and whose emitter is connected to the controlled gain block A implemented by Q₄ and Q₅ as will be later described.

The current controlled second voltage source V₂ is a passive element, in this case a resistor R₂, connected between the emitter of Q₂ and ground.

The source of driving current I_{D} has a first current source I₁, fourth current source I₄, and a third BJT Q₃. I₄ is connected to the collector of Q₂ and the base of Q₃. I₁ is connected to the collector of Q₃. The emitter of Q₃ is connected to ground.

The controlled gain block A has current mirror connected fourth and fifth BJTs Q₄, Q₅. The collector of Q₄ is connected to I₁ and the collector of Q₅ is connected to the output voltage Vₒ. The emitters of Q₄, Q₅ are connected to the emitter of Q₂.

In operation, the collector current of Q₅ is the output current Iₒ. As previously discussed, the condition of operation for symmetry is I_{obias} = ½ Iₒₘₐₓ. To show how the circuit of Figure 3 achieves this condition it is assumed for simplicity that the gain block A has a gain of 1. A current mirror is used to implement the gain block A as the gain of a current mirror is easily controlled during processing by fixing the ratio of the physical areas of the BJTs. It is further assumed that I₄ is approximately equal to I₃, Q₁ and Q₂ have substantially the same gain and R₁ has substantially the same resistance as R₂.

I₃ will flow through Q₁ and I₃ and I₂ will flow through R₁. It will be evident that the voltage drop across the resistor R₁ in the emitter junction of Q₁ creates the reference voltage at the base of Q₁.

Looking at the transconductance stage 5, as the gain of the current mirror comprising the gain block A is unity, the current flowing in the collectors of Q₄ and Q₅ will be substantially the same. The maximum drive current flowing into the gain block A will be I₁, i.e. when Q₃ shuts off. Therefore Iₒₘₐₓ is substantially equal to I₁.

It will be seen by applying an input voltage Vᵢₙ, the circuit 1 is biased and the resultant current flowing in the feedback loop 10 from the gain block A is 2I₁ or 2I_{obias}. Symmetrical clipping, i.e. I_{obias} = ½ Iₒₘₐₓ is achieved by making the current source I₁ substantially equal to the current source I₂. Applying the well-known Kirchhoff's Voltage Law around the emitter-base loop of transistors Q₁ and Q₂, the following expression is obtained: -V_{R1} - V_{BE1} + V_{BE2} + V_{R2}=0.

Since I₃ is substantially the same as I₄, and Q₁ and Q₂ are matched, the V_{b}'s of Q₁ and Q₂ will be substantially the same and drop out of the above expression. Then, V_{R1} is equal to V_{R2}. Applying the well-known Ohms law, the following expression is obtained:${\text{(I}}_{\text{2}} {\text{+ I}}_{\text{3}} {\text{)R}}_{\text{1}} {\text{= (I}}_{\text{4}} {\text{+ 2I}}_{\text{1}} {\text{)R}}_{\text{2}}$${\text{(I}}_{\text{2}} {\text{+ I}}_{\text{3}} {\text{)R}}_{\text{1}} {\text{= (I}}_{\text{4}} {\text{+ 2I}}_{\text{obias}} {\text{)R}}_{\text{2}}$

Since, R₁ is substantially the same as R₂, and I₃ is substantially the same as I₄, the above expression reduces to 2I_{obias} = I₂. Therefore, if I₁ is substantially equal to I₂, then I_{obias} is equal to ½ I₁ or 1/2 I_{Dmax}.

Should I₂ not substantially equal twice I_{obias} then the voltage across R₂ will be too high or too low. Should the voltage across R₃ be too low, Q₂ will turn on harder, drawing current away from the base of Q₃. Less current will flow from I₁ into Q₃ and more into the gain block A. More current will flow out of the gain block A and R₂ to raise the voltage across R₂ until I_{obias} reaches ½ I₂. The opposite effect will occur when the voltage across R₂ is too high. Thus if I₁ is substantially the same as I₂ then I_{obias} will be one-half of Iₒₘₐₓ.

The gain of Q₂ must be sufficiently high not to draw away significant current from Q₃ affecting the mirroring process. Q₃ acts as a current controlled current sink sinking current away from I₁ (all or part of I₁) and Q₄, Q₅ each output a current which is proportional to the current received by Q₄.

It is possible to make devices where I_{obias} is substantially one-half of Iₒₘₐₓ without having I₁ and I₂, I₃ and I₄, R₁ and R₂, Q₁ and Q₂, and Q₄ and Q₅ substantially the same. It is important though to match these components to ensure the ultimate circuit 1 does meet the I_{obias} is substantially one-half Iₒₘₐₓ criterion.

For example, where Q₅ has twice the gain of Q₄ the gain of the gain block A will be approximately 2. Iₒₘₐₓ will be twice I₁. As discussed to achieve symmetrical clipping I_{obias} must be ½ Iₒₘₐₓ and therefore I_{obias} must be equal to I₁. At equilibrium I₂ must be set to 1.5 I₁. In these circumstances I₂ should equal one-half the gain of the gain block A plus one-half, multiplied by I₁.

Other matching of the components will be evident to those skilled in the art.

Another advantage of the circuit 1 is that the small signal voltage gain is independent of the clipping level. For a change in Vᵢₙ, the V_{be} of Q₂ will leg behind the change causing the voltage across R₂ to change. The change in the voltage across R₂ will draw a proportionally different current through the gain block A into R₂. This changes Iₒ by one-half the change in the current in the gain block A. Vₒ will change by a factor of Rₒᵤₜ times the change in Iₒ. Thus the small signal gain of the circuit is approximately$\frac{{\text{R}}_{\text{out}} \text{x α,}}{{\text{R}}_{\text{2}} \left(\text{1 + α}\right)}$ where α is the gain of the gain block A.

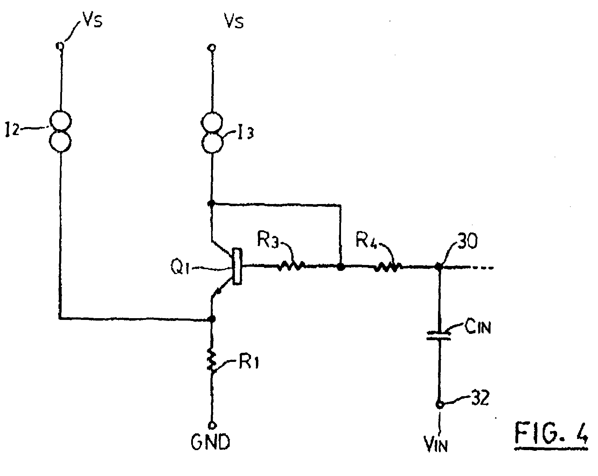

Referring now to Figure 4, a resistor R₃ between the base and collector of Q₁, and a resistor R₄ between the collector of Q₁ and the connection of the coupling capacitor Cᵢₙ and the base of Q₂, may be added to increase the input impedance seen by Vᵢₙ. R₃ and R₄ should be matched, and for simplest implementation be substantially the same, to keep the mirroring effect of Q₁ and Q₂.

## Claims

1. A clipping circuit (1) comprising:
(a) a voltage reference stage (3) having generating means (Q₁, R₁, I₂, I₃) for producing a reference voltage (V_{R}) and an output port (30) connected to said generating means for outputting said reference voltage;
(b) a transconductance stage (5) having control means (Q₂, Q₃) coupled to said output port (30) of said voltage reference stage (3), and a first current source (I₁) coupled to said control means (Q₂, Q₃), said first current source (I₁) including means for generating a drive current having a first pre-determined value;
(c) said transconductance stage (5) further including a gain stage (Q₄,Q₅) coupled to said first current source (I₁ ) for receiving current therefrom, said gain stage (Q₄, Q₅) also being coupled to said control means (Q₂, Q₃);
(d) an input port (32) for receiving an input signal (Vin), said input port (32) being coupled to said output port (30) of said voltage reference stage (3) and to said control means (Q₂, Q₃);
(e) said control means (Q₂, Q₃) including means (Q₂, Q₃) responsive to said input signal (Vin) for controlling the amount of said drive current (I₁) flowing from said first current source (I₁) to said gain stage (Q₄, Q₅);
(f) said gain stage (Q₄, Q₅) including means (Q₄, Q₅) responsive to the amount of said drive current (I₁) received thereby for generating an output current (Iₒ) proportional to the amount of said drive current (I₁) received by said gain stage (Q₄, Q₅) and for making said output current (Iₒ) of said gain stage (Q₄, Q₅) have a pre-determined maximum value proportional to said first pre-determined value (I₁);
(g) and bias means (10, R₂, I₄), including feedback means (10) connect to said control means (Q₂, Q₃) for biasing said control means (Q₂, Q₃) to control said gain stage (Q₄, Q₅) for said output current (Iₒ) of said gain stage (Q₄, Q₅) to have in the absence of any input signal (Vin), a steady-state value which is substantially one-half of said pre-determined maximum value.

2. A circuit according to Claim 1, wherein said pre-determined maximum value of said output current (Iₒ) is substantially equal to said first pre-determined value (I₁).

3. A circuit according to Claim 1 or 2, wherein said feedback means (10) comprises means connected from said gain stage (Q₄, Q₅) to said control means (Q₂, Q₃) for feeding back to said control means (Q₂, Q₃) a current which is proportional to said output current (Iₒ).

4. A circuit according to Claim 3, wherein the voltage reference stage (3) includes a second current source (I₂) and a first current controlled voltage source (R₁, Q₁) coupled to said output port (30) and connected to said second current source (I₂) for generating said reference voltage (V_{R}).

5. A circuit according to Claim 4, wherein said control means (Q₂, Q₃) includes a voltage controlled current sink (Q₂) coupled to said output port (30), a second current controlled voltage source (R₂) connected to said voltage controlled sink (Q₂) and to said feedback means (10), said voltage controlled current sink (Q₂) including means coupled to said first current source (I₁) and responsive to the voltage difference between said second current controlled voltage source (R₂) and said output port (30) for causing said control means to sink current from said first current source (I₁) in proportion to said voltage difference.

6. A circuit according to Claim 5 and further including a pair of voltage supply rails (Vₛ, GND), wherein said voltage reference stage (3) includes a third current source (I₃), said first current controlled voltage source (R₁) comprising a first passive element (R₁) having two terminals and a diode connected first bi-polar junction transistor (Q₁) with its base connected to said output port (30) and to said third current source (I₃) and with its emitter connected to the first terminal of said first passive element (R₁) and to said second current source (I₂), and the second terminal of said first passive element (R₁) being connected to one of said supply rails (GND).

7. A circuit according to Claim 6, wherein said second current controlled voltage source (R₂) comprises a second passive element (R₂) having two terminals, said transconductance stage (5) includes a fourth current source (I₄) and said voltage controlled current sink comprises a second bi-polar junction transistor (Q₂) having its base connected to said output port (30) and its collector connected to said fourth current source (I₄) and coupled to said first current source (I₁) and its emitter connected to one terminal of said second passive element (R₂) and to said feedback means (10) and wherein the other terminal of said second passive element (R₂) is connected to one of said supply rails (GND).

8. A circuit according to Claim 7, wherein the first (Q₁) and second bipolar (Q₂) junction transistors have substantial the same gain, said first (R₁) and second (R₂) passive elements are resistors having substantially the same resistances, and the current in said first (I₁) and second (I₂) current sources are substantially the same.

9. A circuit according to Claim 7, wherein the current in said second (I₂) current source is substantially equal to the current in said first current (I₁) source multiplied by one-half of the gain of the gain stage (Q₄, Q₅) plus one-half.

10. A circuit according to Claim 7, wherein the gain of said gain stage (Q₄, Q₅) is substantially equal to one and the currents in said first (I₁) and second (I₂) current sources are substantially the same.

11. A circuit according to Claim 10, wherein said control means (Q₂, Q₃) includes a current controlled current sink (Q₃) coupled to said voltage controlled current sink (Q₂) and to said first current source (I₁) and having means for sinking current from said first current source (I₁) and for receiving an output current from said voltage controlled current sink (Q₂).

12. A circuit according to Claim 11, wherein said current controlled current sink is a bi-polar junction transistor (Q₃) with its collector connected to said first current source (I₁) and coupled to said gain stage (Q₄, Q₅) and with its base connected to the collector of said second bi-polar junction transistor (Q₂) and to said fourth current source (I₄) and with its emitter connected to one of said supply rails (GND).

13. A circuit according to Claim 12, wherein said gain stage (Q₄, Q₅) is a current mirror having means for receiving current from said first current source (I₁) and for producing a mirror output current (Iₒ) from said transconductance stage (5) and for sending current received from said first current source (I₁) and said output current (Iₒ) to said feedback means (10).

14. A circuit according to Claim 13, wherein said gain stage (Q₄, Q₅) comprises a diode connected fourth bi-polar junction transistor (Q₄) and a fifth bi-polar junction transistor (Q₅), the base and collector of said fourth bi-polar junction transistor (Q₄) being connected to the base of said fifth bi-polar junction transistor (Q₅) the emitters of said fourth (Q₄) and fifth (Q₅) bi-polar junction transistors being connected to said feedback means (10), and the collector of said fourth bi-polar junction transistor (Q₄) being connected to said first current source (I₁) and to the collector of said current controlled current sink (Q₃).

15. A circuit according to Claim 14, wherein the gains of said fourth (Q₄) and fifth (Q₅) bi-polar junction transistors are substantially the same.

16. A circuit according to Claim 14 and further comprising a substantially linear current controlled voltage source (Rₒᵤₜ), and a circuit output port (Vₒ), said linear current controlled voltage source (Rₒᵤₜ) being connected between the other one of said supply rails (Vₛ) and the collector of said fifth bi-polar junction transistor (Q₅), and said circuit output port (Vₒ) being connected to the collector of said fifth bi-polar junction transistor (Q₅).

17. A circuit according to Claim 16, wherein said linear controlled voltage source comprises a third resistor (Rₒᵤₜ).

18. A circuit according to Claim 17, wherein the gain of the circuit is$\frac{{\text{R}}_{\text{out}}}{{\text{R}}_{\text{2}} \left(\text{1 + g}\right)}$ Where, Rₒᵤₜ is the resistance of said third resistor (Rₒᵤₜ), R₂ is the resistance of said second passive element, and g is the gain of said gain stage (Q₄, Q₅).

19. A circuit according to Claim 18, wherein said voltage reference stage (3) further includes a fourth resistor (R₃) and a fifth resistor (R₄), said fourth resistor (R₃) being connected between the base and the collector of said first bi-polar junction transistor (Q₁), and said fifth resistor (R₄) being connected between the collector of the first bi-polar junction transistor (Q₁) and said output port (30) of said reference voltage stage (3).

20. A circuit according to Claim 19, wherein said fourth (R₃) and fifth resistor (R₄) have substantially the same resistance.

21. A circuit according to any one of the preceding claims and further including a coupling capacitor (Cin) and a circuit input (32), said coupling capacitor (Cin) being connected between said circuit input (32) and the input port (32).

## Patentansprüche

1. Begrenzerschaltung (1), umfassend:
(a) eine Spannungsreferenz-Stufe (3) mit einer Erzeugungseinrichtung (Q₁, R₁, I₂, I₃) zum Erzeugen einer Referenzspannung (V_{R}) und einem Ausgangsport (30), der mit der Erzeugungseinrichtung verbunden ist, zum Ausgeben der Referenzspannung;
(b) eine Transkonduktanz-Stufe (5) mit einer Steuereinrichtung (Q₂, Q₃), die mit dem Ausgangsport (30) der Spannungsreferenz-Stufe (3) gekoppelt ist, und mit einer ersten Stromquelle (I₁), die mit der Steuereinrichtung (Q₂, Q₃) gekoppelt ist, wobei die erste Stromquelle (I₁) eine Einrichtung zum Erzeugen eines Ansteuerstroms mit einem ersten vorgegebenen Wert umfaßt;
(c) wobei die Transkonduktanz-Stufe (5) ferner eine Verstärkungsstufe (Q₄, Q₅) umfaßt, die mit der ersten Stromquelle (I₁) zum Empfang eines Stroms davon gekoppelt ist, wobei die Verstärkungsstufe (Q₄, Q₅) auch mit der Steuereinrichtung (Q₂, Q₃) gekoppelt ist;
(d) einen Eingangsport (32) zum Empfangen eines Eingangssignals (Vin), wobei der Eingangsport (32) mit dem Ausgangsport (30) der Spannungsreferenz-Stufe (3) und mit der Steuereinrichtung (Q₂, Q₃) gekoppelt ist;
(e) wobei die Steuereinrichtung (Q₂, Q₃) eine Einrichtung (Q₂, Q₃) umfaßt, die auf das Eingangssignal (Vin) anspricht, zum Steuern des Betrags des Ansteuerstroms (I₁), der von der ersten Stromquelle (I₁) an die Verstärkungsstufe (Q₄, Q₅) fließt;
(f) wobei die Verstärkungsstufe (Q₄, Q₅) eine Einrichtung (Q₄, Q₅) umfaßt, die auf den Betrag des dadurch empfangenen Ansteuerstroms (I₁) anspricht, zum Erzeugen eines Ausgangsstroms (I₀), der proportional zu dem Betrag des von der Verstärkungsstufe (Q₄, Q₅) empfangenen Ansteuerstroms (I₁) ist, und um den Ausgangsstrom (I₀) der Verstärkungsstufe (Q₄, Q₅) auf einen vorgegebenen maximalen Wert zu bringen, der proportional zu dem ersten vorgegebenen Wert (I₁) ist; und
(g) eine Vorspanneinrichtung (10, R₂, I₄) mit einer Rückführungseinrichtung (10), die mit der Steuereinrichtung (Q₂, Q₃) verbunden ist, zum Vorspannen der Steuereinrichtung (Q₂, Q₃), um die Verstärkungsstufe (Q₄, Q₅) zu steuern, so daß der Ausgangsstrom (Iₒ) der Verstärkungsstufe (Q₄, Q₅) bei Abwesenheit irgendeines Eingangssignals (Vin) einen stationären Wert aufweist, der im wesentlichen die Hälfte des vorgegebenen maximalen Werts ist.

2. Schaltung nach Anspruch 1,
**dadurch gekennzeichnet, daß** der vorgegebene maximale Wert des Ausgangsstroms (Iₒ) im wesentlichen gleich zu dem ersten vorgegebenen Wert (I₁) ist.

3. Schaltung nach Anspruch 1 oder 2,
**dadurch gekennzeichnet, daß** die Rückführungseinrichtung (10) eine Einrichtung umfaßt, die von der Verstärkungsstufe (Q₄, Q₅) zu der Steuereinrichtung (Q₂, Q₃) geschaltet ist, zum Zurückführen eines Stroms, der proportional zu dem Ausgangsstrom (Iₒ) ist, an die Steuereinrichtung (Q₂, Q₃).

4. Schaltung nach Anspruch 3,
**dadurch gekennzeichnet, daß** die Spannungsreferenz-Stufe (3) eine zweite Stromquelle (I₂) und eine erste stromgesteuerte Spannungsquelle (R₁, Q₁), die mit dem Ausgangsport (30) gekoppelt und mit der zweiten Stromquelle (Q₂) zum Erzeugen der Referenzspannung (V_{R}) verbunden ist, umfaßt.

5. Schaltung nach Anspruch 4,
**dadurch gekennzeichnet, daß** die Steuereinrichtung (Q₂, Q₃) eine spannungsgesteuerte Stromsenke (Q₂), die mit dem Ausgangsport (30) verbunden ist, eine zweite stromgesteuerte Spannungsquelle (R₂), die mit der spannungsgesteuerten Senke (Q₂) und der Rückführungseinrichtung (10) verbunden ist,umfaßt, wobei die spannungsgesteuerte Stromsenke (Q₂) eine Einrichtung umfaßt, die mit der ersten Stromquelle (I₁) gekoppelt und auf die Spannungsdifferenz zwischen der zweiten stromgesteuerten Spannungsquelle (R₂) und dem Ausgangsport (30) anspricht, um die Steuereinrichtung zu veranlassen, einen Strom von der ersten Stromquelle (I₁) proportional zu der Spannungsdifferenz in eine Senke zu leiten.

6. Schaltung nach Anspruch 5 und ferner umfassend ein Paar von Spannungsversorgungsschienen (V_{S}, GND), wobei die Spannungsreferenz-Stufe (3) eine dritte Stromquelle (I₃) umfaßt, wobei die erste stromgesteuerte Spannungsquelle (R₁) ein erstes passives Element (R₁) mit zwei Anschlüssen und einen Dioden-verschalteten ersten Bipolarübergangstransistor (Q₁) umfaßt, dessen Basis mit dem Ausgangsport (30) und mit der dritten Stromquelle (I₃) verbunden ist und dessen Emitter mit dem ersten Anschluß des ersten passiven Elements (R₁) und mit der zweiten Stromquelle (I₂) verbunden ist, und wobei der zweite Anschluß des ersten passiven Elements (R₁) mit einer der Versorgungsschienen (GND) verbunden ist.

7. Schaltung nach Anspruch 6,
**dadurch gekennzeichnet, daß** die zweite stromgesteuerte Spannungsquelle (R₂) ein zweites passiven Element (R₂) mit zwei Anschlüssen umfaßt, die Transkunduktanz-Stufe (5) eine vierte Stromquelle (I₄) umfaßt und die spannungsgesteuerte Stromsenke einen zweiten Bipolarübergangstransistor (Q₂) umfaßt, dessen Basis mit dem Ausgangsport (30) verbunden ist und dessen Kollektor mit der vierten Stromquelle (I₄) verbunden und mit der ersten Stromquelle (I₁) gekoppelt ist und dessen Emitter mit einem Anschluß des zweiten passiven Elements (R₂) und der Rückführungseinrichtung (10) verbunden ist und wobei der andere Anschluß des zweiten passiven Elements (R₂) mit einer der Versorgungsschienen (GND) verbunden ist.

8. Schaltung nach Anspruch 7,
**dadurch gekennzeichnet, daß** der erste (Q₁) und der zweite bipolare (Q₂) Übergangstransistor im wesentlichen die gleiche Verstärkung aufweisen, das erste (R₁) und zweite (R₂) passive Element Widerstände mit im wesentlichen dem gleichen Widerstand sind und der Strom in der ersten (I₁) und zweiten (I₂) Stromquelle im wesentlichen der gleiche ist.

9. Schaltung nach Anspruch 7,
**dadurch gekennzeichnet, daß** der Strom in der zweiten (I₂) Stromquelle im wesentlichen gleich zu dem Strom in der ersten (I₁) Stromquelle multipliziert mit einer Hälfte der Verstärkung der Verstärkungsstufe (Q₄, Q₅) plus eine Hälfte ist.

10. Schaltung nach Anspruch 7,
**dadurch gekennzeichnet, daß** die Verstärkung der Verstärkungsstufe (Q₄, Q₅) im wesentlichen gleich Eins ist und die Ströme in den ersten (I₁) und zweiten (I₂) Stromquellen im wesentlichen die gleichen sind.

11. Schaltung nach Anspruch 10,
**dadurch gekennzeichnet, daß** die Steuereinrichtung (Q₂, Q₃) eine stromgesteuerte Stromsenke (Q₃) umfaßt, die mit der spannungsgesteuerten Stromsenke (Q₂) und der ersten Stromquelle (I₁) gekoppelt ist und eine Einrichtung aufweist, um einen Strom von der ersten Stromquelle (I₁) an eine Senke zu leiten, und um einen Ausgangsstrom von der spannungsgesteuerten Stromsenke (Q₂) zu empfangen.

12. Schaltung nach Anspruch 11,
**dadurch gekennzeichnet, daß** die stromgesteuerte Stromsenke ein Bipolarübergangstransistor (Q₃) ist, dessen Kollektor mit der ersten (I₁) verbunden und mit der Verstärkungsstufe (Q₄, Q₅) gekoppelt ist und dessen Basis mit dem Kollektor des zweiten Bipolarübergangstransistors (Q₂) und der vierten Stromquelle (I₄) verbunden ist und dessen Emitter mit einer der Versorgungsschienen (GND) verbunden ist.

13. Schaltung nach Anspruch 12,
**dadurch gekennzeichnet, daß** die Verstärkungsstufe (Q₄, Q₅) ein Stromspiegel ist, der eine Einrichtung zum Empfangen eines Stroms von der ersten Stromquelle (I₁) und zum Erzeugen eines Spiegelausgangsstroms (Iₒ) von der Transkonduktanz-Stufe (5) und zum Senden eines von der ersten Stromquelle (I₁) empfangenen Stroms und des Ausgangsstroms (Iₒ) an die Rückführungseinrichtung (10) aufweist.

14. Schaltung nach Anspruch 13,
**dadurch gekennzeichnet, daß** die Verstärkungsstufe (Q₄, Q₅) umfaßt: einen Dioden-verschalteten vierten Bipolarübergangstransistor (Q₄) und einen fünften Bipolarübergangstransistor (Q₅), wobei die Basis und der Kollektor des vierten Bipolarübergangstransistor (Q₄) mit der Basis des fünften Bipolarübergangstransistor (Q₅) verbunden ist, die Emitter des vierten (Q₄) und fünften (Q₅) Bipolarübergangstransistors mit der Rückführungseinrichtung (10) verbunden sind, und der Kollektor des vierten Bipolarübergangstransistors (Q₄) mit der ersten Stromquelle (I₁) und dem Kollektor der stromgesteuerten Stromsenke (Q₃) verbunden ist.

15. Schaltung nach Anspruch 14,
**dadurch gekennzeichnet, daß** die Verstärkungen des vierten (Q₄) und fünften (Q₅) Bipolarübergangstransistors im wesentlichen die gleichen sind.

16. Schaltung nach Anspruch 14 und ferner umfassend eine im wesentlichen lineare stromgesteuerte Spannungsquelle (Rₒᵤₜ) und einen Schaltungsausgangsport (Vₒ), wobei die lineare stromgesteuerte Spannungsquelle (Rₒᵤₜ) zwischen die andere der Versorgungsschienen (Vₛ) und den Kollektor des fünften Bipolarübergangstransistors (Q₅) geschaltet ist und der Schaltungsausgangsport (Vₒ) mit dem Kollektor des fünften Bipolarübergangstransistors (Q₅) verbunden ist.

17. Schaltung nach Anspruch 16,
**dadurch gekennzeichnet, daß** die lineare gesteuerte Spannungsquelle einen dritten Widerstand (Rₒᵤₜ) umfaßt.

18. Schaltung nach Anspruch 17,
**dadurch gekennzeichnet, daß** die Verstärkung der Schaltung folgendermaßen ist:$\frac{{\text{R}}_{\text{out}}}{{\text{R}}_{\text{2}} \left(\text{1 + g}\right)}$ wobei Rₒᵤₜ der Widerstand des dritten Widerstands (Rₒᵤₜ) ist, R₂ der Widerstand des zweiten passiven Elements ist und g die Verstärkung der Verstärkungsstufe (Q₄, Q₅) ist.

19. Schaltung nach Anspruch 18,
**dadurch gekennzeichnet, daß** die Spannungsreferenz-Stufe (3) einen vierten Widerstand (R₃) und einen fünften Widerstand (R₄) umfaßt, wobei der vierte Widerstand (R₃) zwischen die Basis und den Kollektor des ersten Bipolarübergangstransistors (Q₁) geschaltet ist und wobei der fünfte Widerstand (R₄) zwischen den Kollektor des ersten Bipolarübergangstransistors (Q₁) und den Ausgangsport (30) der Referenzspannungsstufe (3) geschaltet ist.

20. Schaltung nach Anspruch 19,
**dadurch gekennzeichnet, daß** der vierte (R₃) und fünfte Widerstand (R₄) im wesentlichen den gleichen Widerstand aufweisen.

21. Schaltung nach einem der vorangehenden Ansprüche und ferner umfassend einen Koppelkondensator (Cin) und einen Schaltungseingang (32), wobei der Koppelkondensator (Cin) zwischen den Schaltungseingang (32) und den Eingangsport (32) geschaltet ist.

22. Schaltung nach Anspruch 21,
**dadurch gekennzeichnet, daß** der vierte und der fünfte Widerstand im wesentlichen den gleichen Widerstand aufweisen.

23. Schaltung nach Anspruch 22, ferner umfassend einen Koppelkondensator und einen Schaltungseingang, wobei der Koppelkondensator zwischen den Schaltungseingang und den Eingangsport geschaltet ist.

## Revendications

1. Un circuit d'écrêtage (1) comprenant :
(a) un étage de référence de tension (3) comprenant des moyens de générations (Q₁, R₁, I₂, I₃) pour produire une tension de référence (V_{R}) et un port de sortie (30) connecté auxdits moyens de générations pour délivrer ladite tension de référence ;
(b) un étage de transconductance (5) comprenant un moyen de commande (Q₂, Q₃) couplé audit port de sortie (30) dudit étage de référence de tension (3), et une première source de courant (I₁) couplée audit moyen de commande (Q₂, Q₃), ladite première source de courant (I₁) comprenant un moyen pour former un courant de commande présentant une première valeur prédéterminée ;
(c) ledit étage de transconductance (5) comprenant en outre un étage de gain (Q₄, Q₅) couplé à ladite première source de courant (I₁) pour en recevoir le courant, ledit étage de gain (Q₄, Q₅) étant aussi couplé audit moyen de commande (Q₂, Q₃) ;
(d) un port d'entrée (32) pour recevoir un signal d'entrée (Vin), ledit port d'entrée (32) étant couplé audit port de sortie (30) dudit étage de référence de tension (3) et audit moyen de commande (Q₂, Q₃) ;
(e) ledit moyen de commande (Q₂, Q₃) incluant des moyens (Q₂, Q₃) sensibles audit signal d'entrée (Vin) pour commander l'intensité dudit courant de commande (I₁) circulant dans lesdites premières sources de courant (I₁) vers ledit étage de gain (Q₄, Q₅) ;
(f) ledit étage de gain (Q₄, Q₅) comprenant des moyens (Q₄, Q₅) sensibles à l'intensité dudit courant de commande (I₁) reçu pour former un courant de sortie (I₀) proportionnel à l'intensité dudit courant de commande (I₁) reçu par ledit étage de gain (Q₄, Q₅) et pour faire en sorte que ledit courant de sortie (I₀) dudit étage de gain (Q₄, Q₅) présente une valeur maximum prédéterminée proportionnelle à ladite première valeur prédéterminée (I₁) ;
(g) et des moyens de polarisation (10, R₂, I₄), comprenant des moyens de réaction (10) connectés audit moyen de commande (Q₂, Q₃) pour polariser lesdits moyens de commande (Q₂, Q₃) de manière à commander ledit étage de gain (Q₄, Q₅) de manière que ledit courant de sortie (I₀) dudit étage de gain présente, en l'absence de tout signal d'entrée (Vin), une valeur de régime permanent qui est sensiblement égale à la moitié de ladite valeur maximum prédéterminée.

2. Un circuit conforme à la revendication 1, dans lequel ladite valeur maximum prédéterminée dudit courant de sortie (I₀) est sensiblement égale à ladite première valeur prédéterminée (I₁).

3. Un circuit conforme à la revendication 1 ou 2, dans lequel ledit moyen de réaction (10) comprend un moyen connecté entre ledit étage de gain (Q₄, Q₅) et ledit moyen de commande (Q₂, Q₃) pour renvoyer audit moyen de commande (Q₂, Q₃) un courant qui est proportionnel audit courant de sortie (I₀).

4. Un circuit conforme à la revendication 3, dans lequel l'étage de référence de tension (3) comprend une deuxième source de courant (I₂) et une première source de tension commandée en courant (R₁, Q₁) couplée audit port de sortie (30) et connectée à ladite deuxième source de courant (I₂) pour former ladite tension de référence (V_{R}).

5. Un circuit conforme à la revendication 4, dans lequel ledit moyen de commande (Q₂, Q₃) comprend un récepteur de courant (Q₂) commandé en tension couplé audit port de sortie (30), une deuxième source de tension commandée en courant (R₂) connectée audit récepteur de courant commandé en tension (Q₂) et audit moyen de réaction (10), ledit récepteur de courant commandé en tension (Q₂) comprenant des moyens couplés à ladite première source de courant (I₁) et sensibles à la différence de tension entre ladite source de tension commandée en courant ((R₂) et ledit port de sortie (30) pour que ledit moyen de commande absorbe du courant venu de ladite première source (I₁), en proportion de ladite différence de tension.

6. Un circuit conforme à la revendication 5, et comprenant en outre une paire de pôles d'alimentation (V_{S}, GND), dans lequel ledit étage de référence de tension (3) comprend une troisième source de courant (I₃), ladite première source de tension commandée en courant (R₁) comprend un premier élément passif (R₁) présentant deux bornes et un premier transistor (Q₁) à jonction bipolaire connecté à travers une diode, dont la base est connectée audit port de sortie (30) et à ladite troisième source de courant (I₃) et dont l'émetteur est connecté à la première bande dudit élément passif (R₁) et à ladite deuxième source de courant (I₂), la deuxième bande dudit premier élément passif (R₁) étant connectée à l'un desdits pôles d'alimentation (GND).

7. Un circuit conforme à la revendication 6, dans lequel ladite deuxième source de tension commandée en courant (R₂) comprend un deuxième élément passif (R₂) présentant deux bornes, ledit étage de transconductance (5) comprenant une quatrième source de courant (I₄) et ledit récepteur de courant commandé en tension comprenant un deuxième transistor à jonction bipolaire (Q₂) dont la base est connectée audit port de sortie (30) et dont le collecteur est connecté à ladite quatrième source de courant (I₄) et couplé à ladite première source de courant (I₁) et dont l'émetteur est connecté à une borne dudit deuxième élément passif (R₂) et audit moyen de réaction (10) et dans lequel l'autre borne dudit deuxième élément passif (R₂) est connectée à l'un desdits pôles d'alimentation (GND).

8. Un circuit conforme à la revendication 7, dans lequel les premier (Q₁) et deuxième (Q₂) transistors à jonction bipolaire présentent sensiblement de même gain, lesdits premier (R₁) et deuxième (R₂) éléments passifs sont des résistances présentant sensiblement la même valeur, et le courant dans lesdites première (I₁) et deuxième (I₂) sources de courant sont sensiblement les mêmes.

9. Un circuit conforme à la revendication 7, dans lequel le courant dans ladite deuxième source de courant (I₂) est sensiblement égal au courant dans ladite première source de courant (I₁) multipliée par la moitié du gain de l'étage de gain (Q₄, Q₅) augmenté d'un demi.

10. Un circuit conforme à la revendication 7, dans lequel le gain dudit étage de gain (Q₄, Q₅) est sensiblement égal à un et les courants dans lesdites première (I₁) et deuxième (I₂) sources de courant sont sensiblement les mêmes.

11. Un circuit conforme à la revendication 10, dans lequel ledit moyen de commande (Q₂, Q₃) comprend un récepteur de courant commandé en courant (Q₃) couplé audit récepteur de courant commandé en tension (Q₂) et à ladite première source de courant (I₁) et comprenant des moyens pour absorber du courant venu de ladite première source de courant (I₁) et pour recevoir un courant de sortie dudit récepteur de courant (Q₂) commandé en tension.

12. Un circuit conforme à la revendication 11, dans lequel ledit récepteur de courant commandé en courant est un transistor à jonction bipolaire (Q₃) dont le collecteur est connecté à ladite première source de courant (I₁) et couplé audit étage de gain (Q₄, Q₅) et dont la base est connectée au collecteur dudit deuxième transistor à jonction bipolaire (Q₂) et à ladite quatrième source de courant (I₄) et dont l'émetteur est connecté à l'un des pôles d'alimentation (GND).

13. Un circuit conforme à la revendication 12, dans lequel ledit étage de gain (Q₄, Q₅) est un miroir de courant comprenant des moyens pour recevoir du courant de ladite première source de courant (I₁) et pour délivrer un courant de sortie miroir (I₀) à partir dudit étage de transconductance (5) et pour envoyer le courant reçu de ladite première source de courant (I₁) et ledit courant de sortie (I₀) audit moyen de réaction (10).

14. Un circuit conforme à la revendication 13, dans lequel ledit étage de gain (Q₄, Q₅) comprend un quatrième transistor à jonction bipolaire ((Q₄) connecté par diode et un cinquième transistor à jonction bipolaire (Q₅), la base et le collecteur dudit quatrième transistor à jonction bipolaire (Q₄) étant connectés à la base dudit cinquième transistor à jonction bipolaire (Q₅) les émetteurs desdits quatrième (Q₄) et cinquième (Q₅) transistors à jonction bipolaire étant connectés audit moyen de réaction (10), et le collecteur dudit quatrième transistor à jonction bipolaire ((Q₄) étant connecté à ladite première source de courant (I₁) et au collecteur dudit récepteur de courant commandé en courant (Q₃).

15. Un circuit conforme à la revendication 14, dans lequel les gains desdits quatrième (Q₄) et cinquième (Q₅) transistors à jonction bipolaire sont sensiblement les mêmes.

16. Un circuit conforme à la revendication 14, et comprenant en outre une source de tension commandée en courant sensiblement linéaire (Rₒᵤₜ) et un port de sortie de circuit (V₀), ladite source linéaire de tension commandée en courant (Rₒᵤₜ) étant connectée entre l'autre desdits pôles d'alimentation (Vₛ) et le collecteur dudit cinquième transistor à jonction bipolaire (Q₅), et ledit port de sortie de circuit (V₀) étant connecté au collecteur dudit cinquième transistor à jonction bipolaire (Q₅).

17. Un circuit conforme à la revendication 16, dans lequel ladite source de tension linéaire commandée comprend une troisième résistance (Rₒᵤₜ).

18. Un circuit conforme à la revendication 17, dans lequel le gain du circuit est${\text{R}}_{\text{out}} {\text{/R}}_{\text{2}} \text{(1 + g)}$ où Rₒᵤₜ est la résistance de ladite troisième résistance (Rₒᵤₜ), R₂ est la résistance dudit deuxième élément passif et g est le gain de l'étage de gain (Q₄, Q₅).

19. Un circuit conforme à la revendication 18, dans lequel ledit étage de référence de tension (3) comprend en outre une quatrième résistance (R₃) et une cinquième résistance (R₄), ladite quatrième résistance (R₃) étant connectée entre la base et le collecteur dudit premier transistor à jonction bipolaire (Q₁), et ladite cinquième résistance (R₄) étant connectée entre le collecteur du premier transistor à jonction bipolaire (Q₁) et ledit port de sortie (30) dudit étage de tension de référence (3).

20. Un circuit conforme à la revendication 19, dans lequel lesdites quatrième (R₃) et cinquième (R₄) résistances présentent sensiblement la même valeur.

21. Un circuit conforme à l'une quelconque des revendications précédentes et comprenant en outre un condensateur de couplage (Cin) et une entrée de circuit (32), ledit condensateur de couplage (Cin) étant connecté entre ladite entrée de circuit (32) et ledit port d'entrée (30).

22. Un circuit conforme à la revendication 21, dans lequel lesdites quatrième et cinquième résistances sont sensiblement de même valeur.

23. Un circuit conforme à la revendication 22, comprenant en outre un condensateur de couplage et une entrée de circuit, ledit condensateur de couplage étant connecté entre ladite entrée de circuit et ledit port d'entrée.
